# EUROPEAN PATENT SPECIFICATION

(11) **EP 1 415 521 B1**
(45) Date of publication and mention of the grant of the patent: **28.06.2006**
(21) Application number: 02749080.4
(22) Date of filing: 30.07.2002
(51) Int. Cl.: H05K 3/28, H05K 9/00

(54) **A METHOD OF PROVIDING RADIO FREQUENCY SCREENING FOR ELECTRIC COMPONENTS**
VERFAHREN ZUR RADIOFREQUENZABSCHIRMUNG VON ELEKTRONISCHEN BAUTEILEN
PROCEDE DE PRODUCTION D'UN ECRAN DE RADIO FREQUENCE POUR COMPOSANTS ELECTRONIQUES

(30) Priority: 11.08.2001 GB 0119673
(43) Date of publication of application: 06.05.2004
(73) Proprietor: UbiNetics (VPT) Limited, Melbourn Hertfordshire SG8 6DP (GB)
(72) Inventor: TOWNSEND, Richard Paul, Syston, Leicester LE7 2PS (GB)
(74) Representative: Mackenzie, Andrew Bryan
(86) International application number: PCT/GB2002/003469
(87) International publication number: WO 2003/015487

(56) References cited:
- EP-A- 0 781 085
- US-A- 5 557 064
- US-A- 5 867 371
- PATENT ABSTRACTS OF JAPAN vol. 1999, no. 01, 29 January 1999 (1999-01-29) & JP 10 264285 A (SHIYOURITSU PLAST KOGYO KK;KURARAY CO LTD), 6 October 1998 (1998-10-06) & US 2002/108704 A1 (UMEZAWA SADAO ET AL) 15 August 2002 (2002-08-15)

## Description

This invention relates to a method of providing radio frequency screening for electronic components.

There is an ever-increasing desire to miniaturise electronic components and improve their compactness. This is particularly relevant in assemblies in which the overall height of the printed circuit board (PCB) and components attached thereto is restricted, such as within a PC card enclosure.

Current radio frequency (RF) screening devices for electronic components are made from sheet metal and are at least 0.2 mm thick. Electrical and mechanical clearance between the screening and the components being screened is also required, adding at least 0.3 - 0.4 mm to the height of the PCB assembly. Plastic moulded screens with metallic coatings are also available but are even thicker than the metal ones and hence occupy even more space within the limited confines of the enclosure.

A further problem with conventional methods of applying screening to electronic components arises in cases in which a PCB assembly is designed without any screening, but then, during testing, screening is found to be required. Since screening was not originally incorporated in the original design, it is often found that adding screening at this late stage is not readily achievable because of its size, and hence re-design of the PCB architecture becomes necessary. This re-design process is potentially expensive and time consuming, and may delay the release of a product onto the market. Since the market for computing and electronic components is ever-changing, such a delay may result in the manufacturer being put at a severe competitive disadvantage.

It is a general object of the present invention to overcome or at least mitigate the problems, shortcomings and disadvantages identified above.

Background art is provided in US-A-5,557,064, which discloses a conformal shield which includes a conformal shield base and a conductive layer.

The present invention is a method of providing radio frequency screening for electronic components, as defined in Claim 1, and a laminate structure for screening electronic components, as defined in Claim 20.

Thus, embodiments of the invention provide a method of providing radio frequency screening for electronic components, the method being performed using: (i) a first laminate comprising an insulating lamina and a shielding lamina; and (ii) a second insulating lamina; and the method comprising the steps: (a) bonding the first laminate and the second insulating lamina together such that the shielding lamina is sandwiched between the two insulating laminae; (b) placing the laminate structure formed in step (a) over an electronic component on a circuit board such that the second insulating lamina is adjacent the component; and (c) joining the shielding lamina to the circuit board at least partly around the component.

Advantageously, by fabricating the radio frequency screening from laminae in such a manner, an extremely thin composite screening structure may be made, potentially 120 µm or even less in thickness. Because it may be made so thin, applying the screening to electronic components on a PCB adds only slightly to the overall assembly height. As a consequence, screening may now be fitted in electronic apparatus where limited height constraints would prevent the use of conventional screening. The use of insulating laminae either side of the shielding lamina enables the screening to touch not only the components shielded inside it, but also enables other components to touch the outer surface of the screening, all without risk of short-circuiting. This thereby enables the overall height of the PCB assembly to be reduced.

Preferably the second insulating lamina is smaller in area than the first laminate, such that the first laminate extends outwardly beyond the second insulating lamina.

Preferably the second insulating lamina is a coverlay pre-coated with an adhesive. This adhesive, which may have a thickness of as little as 35 µm, or even less, advantageously facilitates the bonding of the first laminate and the second insulating lamina.

Preferably the coverlay is a composite of a polymer film and adhesive layer. The polymer film advantageously enables the laminate to be flexible, thereby facilitating its fitting, particularly into confined spaces. Particularly preferably the polymer film in the coverlay is a polyimide.

Most preferably the polyimide film in the coverlay is Kapton (RTM). Most preferably the Kapton film has a thickness of 25 µm.

Preferably the insulating lamina in the first laminate is a polymer. As mentioned above, the use of a polymer advantageously enables the lamina to be flexible.

Particularly preferably the insulating lamina is a polyimide.

Most preferably the polyimide in the insulating lamina is Kapton. Kapton is advantageously readily available as a suitably thin film.

Most preferably the Kapton insulating lamina has a thickness of 25 µm.

Preferably the shielding lamina in the first laminate is metallic. This advantageously provides highly effective shielding against radio frequency interference.

Preferably the metallic lamina is copper. Most preferably the copper lamina has a thickness of 35 µm.

Preferably step (c) of joining the shielding lamina to the circuit board is performed by soldering. This is advantageously facilitated if, as described above, the first laminate extends outwardly beyond the second insulating lamina. Particularly preferably the step of soldering is performed by hot bar soldering. In this technique the exposed edge of the metallic screen is pressed onto solidified solder on a screening can track on the PCB, using a hot implement. This re-melts the solder and attaches the screen to the PCB.

Embodiments of the invention also provide a laminate structure for screening electronic components against radio frequency interference comprising a shielding lamina sandwiched between first and second electrically insulating laminae.

Preferably the first insulating lamina and the shielding lamina are of substantially the same area, and the second insulating lamina is of a slightly smaller area such that the first insulating lamina and the shielding lamina both extend outwards beyond the second insulating lamina.

Particularly preferably one or both of the insulating laminae are made of a polymer.

Particularly preferably the polymer is a polyimide. Most preferably the polymer is Kapton.

Preferably the screening lamina is metallic. Particularly preferably the screening lamina is made of copper.

Preferably one or both of the insulating laminae are 25 µm thick, and the screening lamina is 35 µm thick. These thicknesses advantageously result in an extremely thin screening assembly.

Embodiments of the invention will now be described, by way of example, and with reference to the drawings in which:
Figure 1 illustrates a cross-section view of the laminate materials used to fabricate RF screening, both before bonding (Figure 1a) and after bonding (Figure 1b);
Figure 2 illustrates a plan view from below of a composite laminate screening structure, prior to being attached to a PCB;
Figure 3 illustrates a side view of RF screening having been attached to a PCB;
Figure 4 illustrates a perspective view of RF screening enveloping a component on a PCB; and
Figure 5 illustrates a cross section view through a PCB assembly, showing a component on a PCB having been screened using an embodiment of the invention.

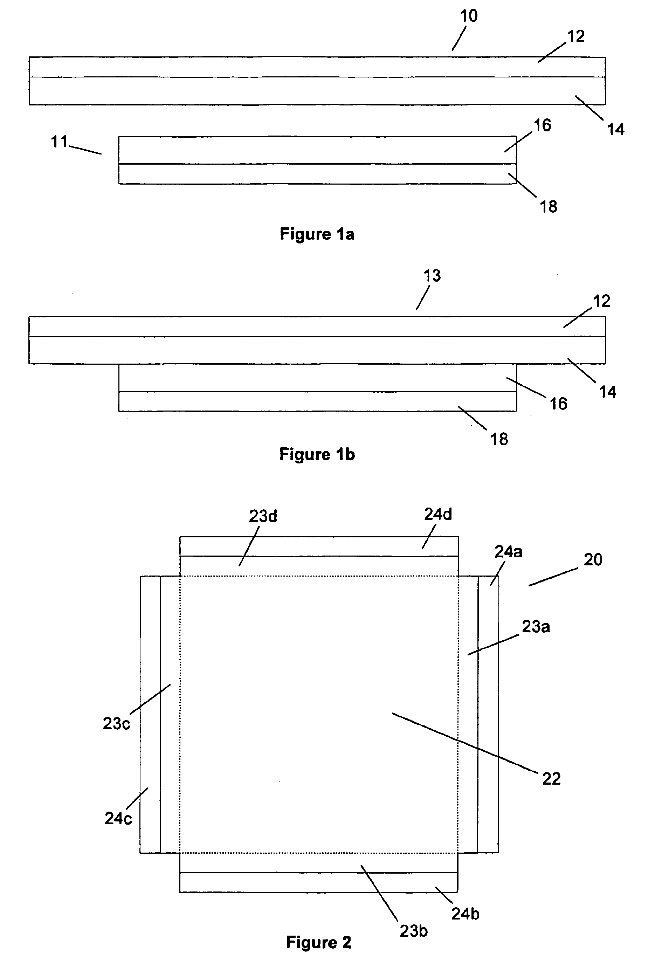

As shown in Figure 1, RF screening may be fabricated by taking two pre-prepared laminate materials, the first 10 being a laminate of Kapton (RTM) 12 and copper 14, and the second 11 being a coverlay of Kapton 18 and adhesive 16. Using the adhesive layer to bond the two laminates, as shown in Figure 1b, a composite laminate screening structure 13 may be fabricated.

A Kapton laminate and coverlay are used since Kapton films are flexible, electrically insulating, and readily available as thin films. Copper is known by those skilled in the art to be an effective RF shield. Each Kapton layer 12,18 is approximately 25 µm in thickness, the copper shielding layer 14 is approximately 35 µm in thickness, and the adhesive layer 16 is also approximately 35 µm thick. This results in a composite laminate screening structure 13 approximately 120 µm in thickness. It will be appreciated by those skilled in the art that thinner layers may be attainable, resulting in an even thinner composite structure, and that alternative materials may be employed.

In the composite laminate screening structure 13, the copper shielding layer 14 is covered on its outer surface (i.e. the surface furthest from the component in use) by a layer of Kapton. This enables other components within the electronic device to come into contact with the shielding without causing short circuiting. The coverlay 11 that is bonded to the inner surface of the copper shielding 14 (i.e. closest to the component in use) is slightly smaller in area than the Kapton/copper outer laminate 10, thereby giving exposed copper regions. These exposed regions of copper 14 are then joined onto a screening can track on a PCB without being impeded by an insulating laminate material in that region.

The planar area of the composite laminate screening structure 13 may potentially be any size. In use it would be a shape and size 20 appropriate for the component that requires RF screening. As shown in Figures 2, 3, 4 and 5, a substantial area 22 of the screening structure 20 is used to cover the top of the component 34. Extending tab-like regions 23a - 23d of the composite structure are shaped to be folded around the sides of the component, whilst the regions 24a - 24d of the structure that present exposed copper extend yet further and are shaped such that they may be folded through approximately a right angle in order to be attached to a screening can track 30 on the PCB 32.

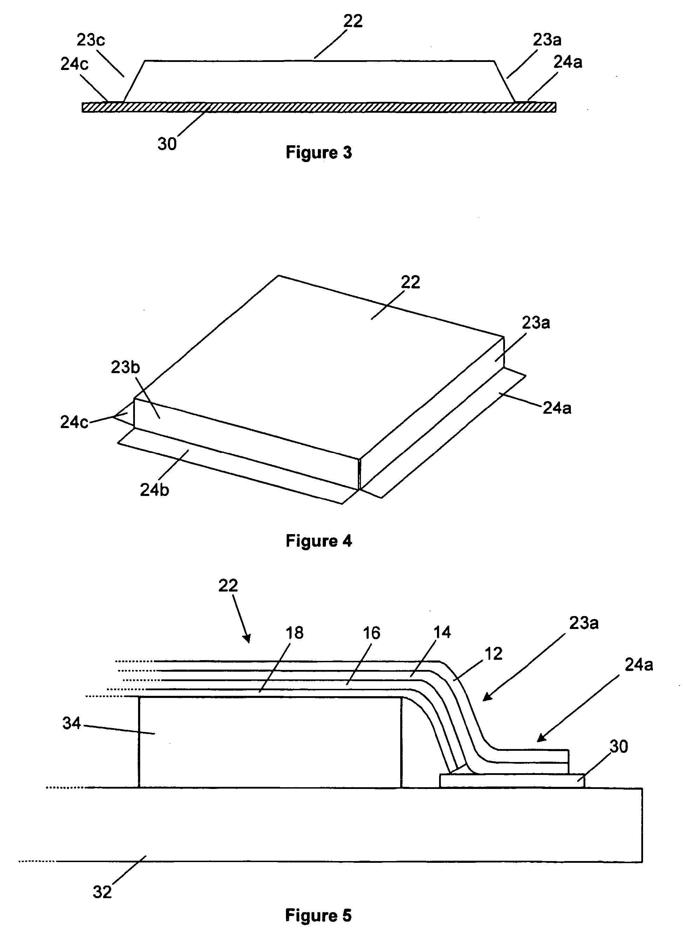

Figures 4 and 5 show the composite structure having been folded such that the side regions 23a - 23d envelop the sides of the component 34, with the exposed copper regions 24a - 24d having been folded around for joining to a screening can track 30 on the PCB 32.

In the overall assembly of a PCB having shielded components, the method of manufacture is as follows: During surface mount component assembly, solder paste is applied to the screening can track on the PCB, and this solder is then re-flowed as the surface mount components (microchips, resistors, etc.) are soldered in place. The screening is then placed in position over the components as desired and is hot bar soldered onto the screening can track. Hot bar soldering involves using a hot bar to press the exposed copper edge of the composite laminate screening structure onto the solidified solder on the screening can track. This causes the solder to be re-melted and attaches the screen to the PCB.

It should be stressed that other insulating materials could be used instead of Kapton, for example, polyester, although this would require attaching to the PCB using double sided conductive adhesive film. Kapton laminates have been chosen for this particular illustration of the invention because they are readily available in the required thickness, and a very thin composite laminate screening structure may easily be fabricated from this material by a manufacturer of flexible PCBs.

Since the copper shielding is insulated on both sides by Kapton, the composite laminate screening structure may be directly in contact with components on the PCB. Since no air gaps are necessary either side of the copper shielding, the overall increase in the height of the PCB assembly is only the thickness of the composite shielding laminate structure, i.e. 120 µm, or even less.

## Claims

1. A method of providing radio frequency screening for electronic components, the method being performed using:
(i) a first laminate (10) comprising an electrically insulating lamina (12) and a shielding lamina (14); and
(ii) a second electrically insulating lamina (18);
and the method comprising the steps:
(a) bonding the first laminate (10) and the second electrically insulating lamina (18) together such that the shielding lamina (14) is sandwiched between the two electrically insulating laminae (12,18);
(b) placing the laminate structure (13) formed in step (a) over an electronic component (34) on a circuit board (32) such that the second electrically insulating lamina (18) is adjacent the component (34); and
(c) joining the shielding lamina (14) to the circuit board (32) at least partly around the component (34);
**characterised in that** the thicknesses of the laminae are such that the thickness of the overall laminate structure (13) is less than or equal to 120 µm.

2. A method as claimed in Claim 1, wherein the thickness of the electrically insulating lamina (12) of the first laminate (10), or the thickness of the second electrically insulting lamina (18), is less than or equal to 25 µm.

3. A method as claimed in Claim 1 or Claim 2, wherein the thickness of the shielding lamina (16) is less than or equal to 35 µm.

4. A method as claimed in any preceding claim, wherein the second electrically insulating lamina (18) is a coverlay (11) pre-coated with an adhesive layer (16).

5. A method as claimed in Claim 4, wherein the thickness of the adhesive layer (16) is less than or equal to 35 µm.

6. A method as claimed in Claim 4 or Claim 5, wherein the coverlay (11) is a composite of a polymer film (18) and an adhesive layer (16).

7. A method as claimed in Claim 6, wherein the polymer film (18) in the coverlay (11) is a polyimide.

8. A method as claimed in Claim 7, wherein the polyimide film (18) in the coverlay (11) is Kapton.

9. A method as claimed in Claim 8, wherein the Kapton film (18) has a thickness of 25 µm.

10. A method as claimed in any preceding claim, wherein the electrically insulating lamina (12) in the first laminate (10) is a polymer.

11. A method as claimed in Claim 10, wherein the polymer in the electrically insulating lamina (12) is a polyimide.

12. A method as claimed in Claim 11, wherein the polyimide in the electrically insulating lamina (12) is Kapton.

13. A method as claimed in Claim 12, wherein the Kapton insulating lamina (12) has a thickness of 25 µm.

14. A method as claimed in any preceding claim, wherein the shielding lamina (14) in the first laminate (10) is metallic.

15. A method as claimed in Claim 14, wherein the metallic lamina (14) is copper.

16. A method as claimed in Claim 15, wherein the copper lamina (14) has a thickness of 35 µm.

17. A method as claimed in any preceding claim, wherein the second electrically insulating lamina (1$) is smaller in area than the first laminate (10), such that the first laminate (10) extends outwardly beyond the second electrically insulating lamina (18).

18. A method as claimed in any preceding claim, wherein the step of joining the shielding lamina (14) to the circuit board (32) is performed by soldering.

19. A method as claimed in 18, wherein the step of soldering is performed by hot bar soldering.

20. A laminate structure (13) for screening electronic components against radio frequency interference comprising a shielding lamina (14) sandwiched between first and second electrically insulating laminae (12,18);
**characterised in that** the thicknesses of the laminae are such that the thickness of the overall laminate structure (13) is less than or equal to 120 µm.

21. A laminate structure as claimed in Claim 20, wherein the thickness of the first electrically insulating lamina (12), or the thickness of the second electrically insulating lamina (18), is less than or equal to 25 µm.

22. A laminate structure as claimed in Claim 20 or Claim 21, wherein the thickness of the shielding lamina (14) is less than or equal to 35 µm.

23. A laminate structure as claimed in any of Claims 20 to 22, wherein the second electrically insulating lamina (18) is a coverlay (11) pre-coated with an adhesive layer (16).

24. A laminate structure as claimed in Claim 23, wherein the thickness of the adhesive layer (16) is less than or equal to 35 µm.

25. A laminate structure as claimed in any of Claims 20 to 24, wherein the first electrically insulating lamina (12) and the shielding lamina (14) are of substantially the same area, and wherein the second electrically insulating lamina (18) is of a slightly smaller area such that the first electrically insulating lamina (12) and the shielding lamina (14) both extend outwards beyond the second electrically insulating lamina (18).

26. A laminate structure as claimed in any of Claims 20 to 25, wherein one or both of the electrically insulating laminae (12,18) are made of a polymer.

27. A laminate structure as claimed in Claim 26, wherein the polymer is a polyimide.

28. A laminate structure as claimed in Claim 27, wherein the polymer is Kapton.

29. A laminate structure as claimed in any of Claims 20 to 28, wherein the shielding lamina (14) is metallic.

30. A laminate structure as claimed in Claim 29, wherein the shielding lamina (14) is made of copper.

## Patentansprüche

1. Verfahren zur Funkfrequenz-Abschirmung für elektronische Bauelemente, wobei das Verfahren durchgerührt wird unter Verwendung von:
(i) einem ersten Laminat (10) mit einer elektrisch isolierenden Laminat-Schicht (12) und einer abschirmenden Laminat-Schicht (14); und
(ii) einer zweiten elektrisch isolierenden Laminat-Schicht (18);
und das Verfahren die folgenden Schritte umfaßt:
(a) Verbinden des ersten Laminats (10) und der zweiten elektrisch isolierenden Laminat-Schicht (18) miteinander, so daß die abschirmende Laminat-Schicht (14) sandwichartig zwischen den beiden elektrisch isolierenden Laminat-Schichten (12, 18) angeordnet ist;
(b) Plazieren der in Schritt (a) ausgebildeten Laminatstruktur (13) über einem elektronischen Bauelement (34) auf einer Leiterplatte (32), so daß die zweite elektrisch isolierende Laminat-Schicht (18) an das Bauelement (34) angrenzt; und
(c) Zusammenfügen der abschirmenden Laminat-Schicht (14) mit der Leiterplatte (32) zumindest teilweise um das Bauelement (34) herum;
**dadurch gekennzeichnet, daß** die Dicken der Laminat-Schichten so beschaffen sind, daß die Dicke der gesamten Laminatstruktur (13) kleiner oder gleich 120 µm ist.

2. Verfahren nach Anspruch 1, wobei die Dicke der elektrisch isolierenden Laminat-Schicht (12) des ersten Laminats (10) oder die Dicke der zweiten elektrisch isolierenden Laminat-Schicht (18) kleiner oder gleich 25 µm ist.

3. Verfahren nach Anspruch 1 oder 2, wobei die Dicke der abschirmenden Laminat-Schicht (14) kleiner oder gleich 35 µm ist.

4. Verfahren nach einem beliebigen der vorhergehenden Ansprüche, wobei die zweite elektrisch isolierende Laminat-Schicht (18) ein Überzug (11) ist, der mit einer Haftschicht (16) vorbeschichtet ist.

5. Verfahren nach Anspruch 4, wobei die Dicke der Haftschicht (16) kleiner oder gleich 35 µm ist.

6. Verfahren nach Anspruch 4 oder 5, wobei der Überzug (11) ein Verbundmaterial aus einem Polymerfilm (18) und einer Haftschicht (16) ist.

7. Verfahren nach Anspruch 6, wobei der Polymerfilm (18) im Überzug (11) ein Polyimid ist.

8. Verfahren nach Anspruch 7, wobei der Polyimidfilm (18) im Überzug (11) Kapton ist.

9. Verfahren nach Anspruch 8, wobei der Kaptonfilm (18) eine Dicke von 25 µm hat.

10. Verfahren nach einem beliebigen der vorhergehenden Ansprüche, wobei die elektrisch isolierende Laminat-Schicht (12) im ersten Laminat (10) ein Polymer ist.

11. Verfahren nach Anspruch 10, wobei das Polymer in der elektrisch isolierenden Laminat-Schicht (12) ein Polyimid ist.

12. Verfahren nach Anspruch 11, wobei das Polyimid in der elektrisch isolierenden Laminat-Schicht (12) Kapton ist.

13. Verfahren nach Anspruch 12, wobei die isolierende Kaptonlaminatschicht (12) eine Dicke von 25 µm hat.

14. Verfahren nach einem beliebigen der vorhergehenden Ansprüche, wobei die abschirmende Laminat-Schicht (14) im ersten Laminat (10) metallisch ist.

15. Verfahren nach Anspruch 14, wobei die metallische Laminat-Schicht (14) Kupfer ist.

16. Verfahren nach Anspruch 15, wobei die Kupferlaminatschicht (14) eine Dicke von 35 µm hat.

17. Verfahren nach einem beliebigen der vorhergehenden Ansprüche, wobei die zweite elektrisch isolierende Laminat-Schicht (18) eine kleinere Fläche als das erste Laminat (10) hat, so daß das erste Laminat (10) sich nach außen jenseits der zweiten elektrisch isolierenden Laminat-Schicht (18) erstreckt.

18. Verfahren nach einem beliebigen der vorhergehenden Anspruche, wobei der Schritt des Zusammenfügens der abschirmenden Laminat-Schicht (14) mit der Leiterplatte (32) durch Löten erfolgt.

19. Verfahren nach einem beliebigen der vorhergehenden Ansprüche, wobei der Lötschritt durch Heißstangenlöten erfolgt.

20. Laminatstruktur (13) zur Abschinmung elektronischer Bauelemente gegen Funkfrequenzinterferenz, die eine abschirmende Laminat-Schicht (14) umfasst, die sandwichartig zwischen einer ersten und einer zweiten elektrisch isolierenden Laminat-Schicht (12, 18) angeordnet ist;
**dadurch gekennzeichnet, daß** die Dicken der Laminat-Schichten so beschaffen sind, daß die Dicke der gesamten Laminatstruktur (13) kleiner oder gleich 120 µm ist.

21. Laminatstruktur nach Anspruch 20, wobei die Dicke der ersten elektrisch isolierenden Laminat-Schicht (12) oder die Dicke der zweiten elektrisch isolierenden Laminat-Schicht (18) kleiner oder gleich 25 µm ist.

22. Laininatstruktur nach Anspruch 20 oder 21, wobei die Dicke der abschirmenden Laminat-Schicht (14) kleiner oder gleich 35 µm ist.

23. Laminatstruktur nach einem der Ansprüche 20 bis 22, wobei die zweite elektrisch isolierende Laminat-Schicht (18) ein Überzug (11) ist, der mit einer Haftschicht (16) vorbeschichtet ist.

24. Laminatstruktur nach Anspruch 23, wobei die Dicke der Haftschicht (16) kleiner oder gleich 35 µm ist.

25. Laminatstruktur nach einem der Ansprüche 20 bis 24, wobei die erste elektrisch isolierende Laminat-Schicht (12) und die abschirmende Laminat-Schicht (14) im wesentlichen die gleiche Fläche haben und wobei die zweite elektrisch isolierende Laminat-Schicht (18) eine geringfügig kleinere Fläche hat, so daß die erste elektrisch isolierende Laminat-Schicht (12) und die abschirmende Laminat-Schicht (14) sich beide nach außen jenseits der zweiten elektrisch isolierenden Laminat-Schicht (18) erstrecken.

26. Laminatstruktur nach einem der Ansprüche 20 bis 25, wobei eine oder beide der elektrisch isolierenden Laminat-Schichten (12, 18) aus einem Polymer bestehen.

27. Laminatstruktur nach Anspruch 26, wobei das Polymer ein Polyimid ist.

28. Laminatstruktur nach Anspruch 27, wobei das Polymer Kapton ist.

29. Laminatstruktur nach einem der Anspruche 20 bis 28, wobei die abschirmende Laminat-Schicht (14) metallisch ist.

30. Laminatstruktur nach Anspruch 29, wobei die abschirmende Laminat-Schicht (14) aus Kupfer besteht.

## Revendications

1. Procédé de réalisation d'une action d'écran de radiofréquence pour des composants électroniques, le procédé étant réalisé en utilisant :
(i) un premier stratifié (10) qui comprend une couche électriquement isolante (12) et une couche de blindage (14) ; et
(ii) une seconde couche électriquement isolante (18),
et le procédé comprenant les étapes de :
(a) liaison du premier stratifié (10) et de la seconde couche électriquement isolante (18) ensemble de telle sorte que la couche de blindage (14) soit prise en sandwich entre les deux couches électriquement isolantes (12, 18) ;
(b) placement de la structure stratifiée (13) qui est formée au niveau de l'étape (a) sur un composant électronique (34) sur une carte de circuit (32) de telle sorte que la seconde couche électriquement isolante (18) soit adjacente au composant (34) ; et
(c) jonction de la couche de blindage (14) sur la carte de circuit (32) au moins partiellement autour du composant (34),
**caractérisé en ce que** les épaisseurs des couches sont telles que l'épaisseur de la structure stratifiée globale (13) soit inférieure ou égale à 120 micromètres.

2. Procédé selon la revendication 1, dans lequel l'épaisseur de la couche électriquement isolante (12) du premier stratifié (10) ou l'épaisseur de la seconde couche électriquement isolante (18) est inférieure ou égale à 25 micromètres.

3. Procédé selon la revendication 1 ou 2, dans lequel l'épaisseur de la couche de blindage (16) est inférieure ou égale à 35 micromètres.

4. Procédé selon l'une quelconque des revendications précédentes, dans lequel la seconde couche électriquement isolante (18) est un recouvrement (11) prérevêtu d'une couche adhésive (16).

5. Procédé selon la revendication 4, dans lequel l'épaisseur de la couche adhésive (16) est inférieure ou égale à 35 micromètres.

6. Procédé selon la revendication 4 ou 5, dans lequel le recouvrement (11) est un composite d'un film en polymère (18) et d'une couche adhésive (16).

7. Procédé selon la revendication 6, dans lequel le film en polymère (18) dans le recouvrement (11) est un polyimide.

8. Procédé selon la revendication 7, dans lequel le film en polyimide (18) dans le recouvrement (11) est du Kapton.

9. Procédé selon la revendication 8, dans lequel le film en Kapton (18) présente une épaisseur de 25 micromètres.

10. Procédé selon l'une quelconque des revendications précédentes, dans lequel la couche électriquement isolante (12) dans le premier stratifié (10) est un polymère.

11. Procédé selon la revendication 10, dans lequel le polymère dans la couche électriquement isolante (12) est un polyimide.

12. Procédé selon la revendication 11, dans lequel le polyimide dans la couche électriquement isolante (12) est du Kapton.

13. Procédé selon la revendication 12, dans lequel la couche isolante en Kapton (12) présente une épaisseur de 25 micromètres.

14. Procédé selon l'une quelconque des revendications précédentes, dans lequel la couche de blindage (14) dans le premier stratifié (10) est métallique.

15. Procédé selon la revendication 14, dans lequel la couche métallique (14) est du cuivre.

16. Procédé selon la revendication 15, dans lequel la couche en cuivre (14) présente une épaisseur de 35 micromètres.

17. Procédé selon l'une quelconque des revendications précédentes, dans lequel la seconde couche électriquement isolante (18) présente une surface inférieure à celle du premier stratifié (10) de telle sorte que le premier stratifié (10) s'étend vers l'extérieur au-delà de la seconde couche électriquement isolante (18).

18. Procédé selon l'une quelconque des revendications précédentes, dans lequel l'étape de jonction de la couche de blindage (14) sur la carte de circuit (32) est réalisée par soudure.

19. Procédé selon la revendication 18, dans lequel l'étape de soudure est réalisée au moyen d'une soudure par barre chaude.

20. Structure stratifiée (13) pour blinder des composants électroniques vis-à-vis d'une interférence de radiofréquence comprenant une couche de blindage (14) qui est prise en sandwich entre des première et seconde couches électriquement isolantes (12, 18),
**caractérisée en ce que** les épaisseurs des couches sont telles que l'épaisseur de la structure stratifiée globale (13) est inférieure ou égale à 120 micromètres.

21. Structure stratifiée selon la revendication 20, dans laquelle l'épaisseur de la première couche électriquement isolante (12) ou l'épaisseur de la seconde couche électriquement isolante (18) est inférieure ou égale à 25 micromètres.

22. Structure stratifiée selon la revendication 20 ou 21, dans laquelle l'épaisseur de la couche de blindage (14) est inférieure ou égale à 35 micromètres.

23. Structure stratifiée selon l'une quelconque des revendications 20 à 22, dans laquelle la seconde couche électriquement isolante (18) est un recouvrement (11) qui est prérevêtu d'une couche adhésive (16).

24. Structure stratifiée selon la revendication 23, dans laquelle l'épaisseur de la couche adhésive (16) est inférieure ou égale à 35 micromètres,

25. Structure stratifiée selon l'une quelconque des revendications 20 à 24, dans laquelle la première couche électriquement isolante (12) et la couche de blindage (14) sont sensiblement de la même surface et dans laquelle la seconde couche électriquement isolante (18) est d'une surface légèrement inférieure de telle sorte que la première couche électriquement isolante (12) et la couche de blindage (14) s'étendent toutes deux vers l'extérieur au-delà de la seconde couche électriquement isolante (18).

26. Structure stratifiée selon l'une quelconque des revendications 20 à 25, dans laquelle l'une des couches électriquement isolantes (12, 18) ou les deux sont réalisées à partir d'un polymère.

27. Structure stratifiée selon la revendication 26, dans laquelle le polymère est un polyimide.

28. Structure stratifiée selon la revendication 27, dans laquelle le polymère est du Kapton.

29. Structure stratifiée selon l'une quelconque des revendications 20 à 28, dans laquelle la couche de blindage (14) est métallique.

30. Structure stratifiée selon la revendication 29, dans laquelle la couche de blindage (14) est réalisée en cuivre.
